# EUROPÄISCHE PATENTANMELDUNG

(11) **EP 2 476 723 A1**
(43) Veröffentlichungstag der Anmeldung: **18.07.2012**
(21) Anmeldenummer: 11401676.9
(22) Anmeldetag: 20.12.2011
(51) Int. Cl.: C08J 7/04, C23C 18/16, C23C 18/20, C23C 18/28, C25D 5/02, H05K 1/03, H05K 3/18, H05K 3/38

(54) **Verfahren zur selektiven Metallisierung eines Substrats sowie ein nach diesem Verfahren hergestellter Schaltungsträger**

(30) Priorität: 14.01.2011 DE 102011000138
(71) Anmelder: LPKF Laser & Electronics AG, 30827 Garbsen (DE)
(72) Erfinder: John, Wolfgang, 31535 Neustadt am Rübenberge (DE); Rösener, Bernd, 32457 Porta Westfalica (DE)
(74) Vertreter: Scheffler, Jörg

(57) **Zusammenfassung**

Die Erfindungbetrifftein Verfahren zur selektiven Metallisierung der Oberflächen von Kunststoffsubstraten sowie einen nach diesem Verfahren hergestellten Schaltungsträger, bei dem die Kunststoffsubstrate als Additive natürliche oder synthetisch hergestellte Tektoalumosilikate enthalten, die mittels einer ablativen Behandlung der Oberfläche des Kunststoffsubstrats zugänglich gemacht, bekeimt und schließlich außenstromlos metallisiert werden.

## Beschreibung

Die Erfindung betrifft ein Verfahren zur selektiven Metallisierung einesSubstratsmiteinem wesentlichen Materialanteilauseinem Kunststoff, welcherein Additivaufnimmtoderträgt, bei dem in den zu metallisierenden Bereichen eine oberflächennahe Schicht des Substrats mittels eines Ablationsverfahrens abgetragen wird. Weiterhinbetrifft die Erfindungeinen nach diesem Verfahren hergestellten Schaltungsträger.

Seitdem es Anfang der sechziger Jahre des letzten Jahrhunderts erstmals gelang, spritzgegossene Kunststoffteile aus ABS (Acrylnitril-Butadien-Styrol) haftfest nasschemisch zu metallisieren, hat es eine Fülle von Verfahrensentwicklungen gegeben, auch technische Kunststoffe, wie z. B. Polyamide (PA), Polybutylenterephthalat (PBT) oder Polycarbonat (PC) mit Dauergebrauchstemperaturenbisca. 150 °C undthermischnoch höher belastbare Hochleistungskunststoffe, wie z. B. Polyetherimid (Pl), Polyphenylensulfid (PPS), Polyetheretherketon (PEEK) oder Liquid Crystal Polymer (LCP), zum Zweckeder funktionellen und/oder dekorativen Oberflächenveredelung haftfest zu metallisieren.

Verallgemeinernd kann man die Vorbehandlung von Kunststoffoberflächen vor ihrer Metallisierung in die Prozessschritte Konditionierung, Bekeimung und Aktivierung unterteilen.

In der Fachliteratur werden eine ganze Reihe unterschiedlicher mechanischer, chemischer und physikalischer Methoden zur Oberflächenvorbehandlung von Kunststoffoberflächen beschrieben, dieinsbesonderebeidenchemischen Verfahrenoftauf die Naturder Kunststoffoberfläche abgestimmt sind. Wesentlich bei all diesen Methoden ist das Aufschließen der Kunststoff-Substratoberfläche, um den erforderlichen Haftgrund für die abzuscheidende Metallschichtzugenerieren. Beidenchemischen Verfahrenerreichtman durch Beizenoder Quellenund Herauslösenvon Bestandteilenaus der Oberflächeeine Aufrauung, die sich gleichzeitig in einer Oberflächenvergrößerung, sehr oft verbunden mit einer Hydrophilierung, manifestiert.

So offenbart die Patentanmeldung DE 100 54 544 A1 ein Verfahren zum chemischen Metallisieren von Oberflächen, insbesondere von Oberflächen aus Acrylnitril-Butadien-Styrol-Copolymerisaten (ABS) und deren Mischungen (Blends) mit anderen Polymeren, indem deren Oberflächen in hochkonzentrierten Lösungen von Cr(Vl)-lonen in Schwefelsäure gebeizt werden.

Es gehört zum allgemeinen Verständnis des Fachmanns (siehe auch: Schriftenreihe Galvanotechnik des Eugen G. Leuze Verlags; Schuchentrunk, R. et al.; "Kunststoffmetallisierung", Bad Saulgau 2007; ISBN 3-87480-225-6), dass der aggressive Beizangriff dieser Lösungen die Butadien-Komponente aus der ABS-Substratmatrix oberflächlichoxidativabbaut sowie die Oxidationsprodukteselektivaus der Oberfläche herauslöst und so eine poröse, mit Kavernen behaftete Substratoberfläche entstehen lässt, die für die anschließende Edelmetallbekeimung und chemische Metallisierung für eine gute Haftfestigkeit durch den sogenannten "Druckknopfeffekf' sorgt.

Die Schrift EP 0 146 724 B1 offenbart zur Vorbehandlung der Oberfläche von Formteilen aus Polyamid vor der stromlosen Metallisierung die Behandlung in einem Gemisch von Halogeniden der Elemente der Gruppe IA oder IIA des Periodensystems mit Sulfaten, Nitraten oder Chloriden der Gruppen IIIA, IIIB, IVA, IVB, VIA und VIIA oder von Nichtedelmetallen der Gruppe VIIIA des Periodensystems in einem nicht ätzenden, organischen Quell- oder Lösungsmittel und einer metallorganischen Komplexverbindung von Elementen der Gruppe IB oder VIIIA des Periodensystems.

Der Aufgabe der Vorbehandlung von Kunststoffen und speziell von Polyamiden vor der chemischen Metallisierung widmet sich auch die Schrift DE 10 2005 051 632 B4 mit einem Verfahren, bei dem die Kunststoffoberflächen mit einer ein Halogenid und/oder Nitrat der Gruppe bestehend aus Na, Mg, Al, Si, Sc, Ti, V, Cr, Mn, Fe, Co, Ni, Cu, Ca und Zn enthaltenden Beizlösung behandelt wird, wobei diese Lösung ein lösliches Fluorid in Form einer Koordinationsverbindung der allgemeinen Formel M¹(HF₂) enthält.

Zur Herstellung selektiv metallisierter Kunststoffbauteile bediente man sich in der Vergangenheit sehr häufig des Zweikomponenten-Spritzgießverfahrens. Speziell in den 90er Jahrendesletzten Jahrhundertshattensichfür die Herstellungvonz. B. spritzgegossenen dreidimensionalen Schaltungsträgern (3-D MID) zwei mögliche Verfahrenswege herauskristallisiert, nämlich das SKW-Verfahren (Sankyo Kasei Wiring) und das PCK-Verfahren (Printed Circuit Board Kollmorgan), siehe auch "Proceedings of 1st International Congress Molded Interconnect Devices", September, 28th-29th, 1994, Erlangen, Germany, published by Research Association Interconnect Devices 3-D MID e.V., ISBN 3-87525-062-1.

Kennzeichen beider Verfahren ist die Verwendung einer Kombinationeines metallisierfähigen oder für die Metallisierung aktivierfähigen Kunststoffmaterials mit einem Material, welches nicht metallisierfähig ist oder nicht für die Metallisierung aktivierfähig vorbehandelt werden kann.

Im Zuge der Weiterentwicklung dieser Technik benutzt man inzwischen als Werkstoffe für die metallisierfähige Komponente kernkatalytische Kunststoffe, die zum Beispiel mit Palladium dotiert sind. Nach dem Zweikomponentenspritzguss aus einem palladiumdotiertenund einem nicht-palladiumdotierten Kunststoff müssen die Oberflächenbereiche des Spritzgussteils, in denen die kernkatalytische Kunststoffkomponente vorliegt, so vorbehandelt werden, dass eine Zugänglichkeit des stromlosen Metallisierbads zu den im Kunststoff eingelagerten Palladiumkeimen möglich wird. Im Falle von LCP als einem häufig für MID-Teile genutzten Hochleistungswerkstoff erfolgt dies durch Beizen der Oberfläche in stark alkalischen Lösungen.

So ist unter anderem aus der Schrift DE 100 54 088 C1 bekannt, dass dreidimensionale Schaltungsträger (3-D MID) aus einer vorteilhaften Kombination von Hochleistungswerkstoffen wie LCP und syndiotaktischem Polystyrol im Zweikomponenten-Spritzgussverfahren so hergestellt werden können, dass eine selektive Metallisierung der kernkatalytischen LCP-Komponente nach dem Beizen in 10-15 normaler Natronlauge bei Temperaturen zwischen 60° und 90 °C erfolgen kann. Durch diesen Beizschritt wird die Spritzhaut des LCP aufgelöst und es werden die im Kunststoff eingebetteten mineralischen Füllstoffpartikel herausgelöst. Auf diese Weise wird wieder eine porige Oberfläche erzeugt, die für einen guten Haftgrund der anschließend abgeschiedenen Metallisierung sorgt.

Nach der Konditionierung der Kunststoffoberfläche erfolgt die Bekeimung. Beim Bekeimen findet eine Adsorption von Palladiumverbindungen an der konditionierten Kunststoffoberfläche statt. Dies geschieht zumeist in salzsauren Lösungen, die das Palladium entweder ionogen oder kolloidal enthalten. Die ionogene Bekeimung erfolgt meist mittels zweifach geladenem Pd²⁺, hauptsächlich in Form des Tetrachloropalladat(ll)ions [PdCl₄]²⁻. Die kolloidale Bekeimung enthält dagegen metallisches Palladium,welchesdurch ein Schutzkolloid in Lösung gehalten wird. Als Schutzkolloid wird meist Zinn(ll)chlorid SnCl₂ eingesetzt. Dieses bildet um die Palladium-Zinn-Cluster eine negativ geladene Schutzhülle, die mit den Dipolen der Wassermoleküle in Wechselwirkung tretenkann,wodurchdie Metallcluster in Lösung gehalten werden. Die Clusterdurchmesser bewegen sich im Bereich zwischen 2 und 10 nm. Die Struktur der kolloidal gelösten Palladium-Zinn-Cluster wurde zum Beispiel beschrieben in R. L. Cohen; K. W. West, J. Electrochem. Soc. 120, 502 (1973).

Im letzten Schritt vor der eigentlichen Metallisierung der Kuststoffoberfläche schließt sich an die Bekeimung die Aktivierung, d.h. die Erzeugung von metallischen Palladiumkeimen auf der vorbehandelten Oberfläche an.

Wurde ionogen bekeimt, werden die adsorbierten Palladiumverbindungen durch ein Reduktions mittelwie zum Beispiel Natriumhypophosphit NaH₂PO₂ oder Dimethylaminoboran (CH₃)₂NH-BH₃ zum metallischen Palladium reduziert.

Nach der kolloidalen Palladium-Bekeimung, wo das metallische Palladium schon vorhanden, aberim Schutzkolloidgebundenist, erfolgt die Zerstörungdes Schutzkolloids auf der Substratoberfläche bei gleichzeitiger Adsorption von metallischem Palladium auf der Kunststoffoberfläche. Der Fachmann spricht hier von einer Beschleunigung. Als Beschleuniger werden zum Beispiel Oxalsäure HOOC-COOH oder Tetrafluorborsäure HBF₄ angewandt, die die SnCl₂-Hülle des Schutzkolloids entfernen und so dafür sorgen, dass die von der Schutzhülle befreiten Palladiumcluster direkt auf der Kunststoffoberfläche angelagert werden.

Im anschließenden Metallisierschritt, der hier ausschließlich als außenstromloser und somit chemischer Metallisierschritt betrachtet werden soll, stören die im Anschluss an die ionogene oder kolloidale Bekeimung erzeugten Palladiumatome das metastabile Gleichgewicht der Elektrolyte, indem sie die Reduktionsreaktion zwischen den im Elektrolyten befindlichen Metallionen und dem Reduktionsmittel katalysieren. Ist die Reaktion erst einmal initiiert, läuft die Metallabscheidung autokatalytisch weiter und das abgeschiedene Metall katalysiert dann selbst die Reduktionsreaktion, ähnlich wie die Palladiumcluster.

Eine besonders große Rolle spielt die selektive Metallisierung von Kunststoffbauteilen auf dem Gebiet der dreidimensionalen spritzgegossenen Schaltungsträger (Molded Interconnect Devices, 3-D MID). Diese Technologie hat in den letzten Jahren immer mehr an Bedeutung gewonnen, da sie bei der Konzeption mechatronischer Systeme die nahezu beliebige Gestaltungsfreiheit des Kunststoffspritzgussverfahrens und dessen mechanische Funktionalität mit den Möglichkeiten der Schaltungsträgererzeugung ideal zu verbinden vermag.

Eine Übersicht über die verschiedenen Herstellungsverfahren von MID findet sich im Handbuch "Herstellungsverfahren, Gebrauchsanforderungen und Materialkennwerte Räumlicher Elektronischer Baugruppen 3-D MID", Herausgeber: Forschungsvereinigung Räumliche Elektronische Baugruppen 3-D MID e.V. D-Erlangen, Carl Hanser Verlag, München 2004 (ISBN 3-446-22720-2).

Neben den schon erwähnten Zweikomponenten-Spritzgießverfahren, bei denen metallisierbare und nicht-metallisierbare Kunststoffe in einem Bauteil vereint werden und danach die an der Oberfläche meist als Leiterbahnen ausgebildeten Schaltungsbere iche aus der metallisierbaren Komponente selektiv metallisiert werden können, hat die sogenannte Laser-Direkt-Strukturierung in den letzten Jahren einen bedeutenden Marktanteil bei der Fertigung von MIDs gewonnen.

Die wesentlichen Prinzipien zur Herstellung von Leiterbahnen und des Verfahrens zur Herstellung derselben werden in der Schrift EP 1 274 288 B1 offenbart. Hier werden in die Kunststoffe,diealsSchaltungsträgerVerwendungfinden,Additiveganzallgemein bestehend aus Metalloxiden der d- und f-Gruppe des Periodensystems, in besonderer Ausführung bestehend aus Spinellen und in weitergehender Präzisierung bestehend aus kupferhaltigen Spinellen, eincompoundiert und die erhaltenen Kunststoffbauteile anschließend mit der elektromagnetischen Strahlung ei nes Lasers bearbeitet. Dabei wird an der Oberfläche des Kunststoffbauteils ein geringfügiger Abtrag verbunden mit einer Zerklüftung der Polymeroberfläche erreicht, der einhergeht mit der gleichzeitigen Bildung katalytisch wirksamer Keime, die aus der Wirkung der Laserstrahlung mit dem im Kunststoff eingearbeiteten Additiv herrühren. Die so aktivierten Bauteile können anschließend in einem stromlosen Kupferbad selektiv verkupfert werden.

Trotz seines großen Markterfolgs bei der Fertigung von MIDs und insbesondere im Bereich der Fertigung von Mobilfunkantennen hat das Verfahren den Nachteil, dass die verwendeten Additive eine schwarze Eigenfarbe besitzen und somit bei den Konzentrationen, die notwendig sind, um eine ausreichende Aktivität für die anschließende Metallisierung zu erzeugen, die additivierten Kunststoffe bzw. die daraus hergestellten Spritzgussteile selbst eine schwarze Farbe annehmen. Das schränkt die Designfreiheit zum Beispiel im Bereich der Mobiltelefone dadurch ein, dass Covers, die sich zweckmäßigerweise auf der Innenseite mit metallischen Antennenstrukturen beaufschlagen lassen, auf der Außenseite nur in schwarzer Farbe herstellbar sind und man diese in einem zusätzliche n Schritt entsprechend den Designwünschen zum Beispiel durch Lackiertechniken einfärben muss.

Einweiterer Nachteildes Verfahrensbestehtindem Umstand, dass die Werkstoffe, die - und dazu zählen insbesondere ABS und PC/ABS-Blends, die fast ausschließlich zur Fertigung von Antennen für MobiltelefoneVerwendungfinden - während der Laserstrukturierung bzw. -aktivierung besonders leicht zur Schmelzebildung neigen und damit die aktivierten Additive vermutlich teilweise wieder verkapseln werden, sehr schwer zu metallisieren sind. Häufig werden in der Praxis diese laserstrukturierten Teile in einem zweistufigen Kupfer-Metallisierprozess gefahren, wobei das erste Kupferbad aus einem hochaktiven chemischen Kupferelektrolyten besteht, in dem die Teile mit ca. 1-3 um Kupfer "anverkupfert" werden, um sie dann in einem normal aktivierten Kupferelektrolytenbiszur Sollschichtdicke weiter zu verkupfern. Der Fachmann weiß, dass die Lebensdauer eines hochaktivierten Kupferbads sehr schnell erreicht ist und dieses dann verworfen und einer Entsorgung zugeführt werden muss. Diese zweistufige Kupferbadfolge ist folglich teuer und erfordert zusätzlicheKupfertankkapazitäten,dieentwedereinelängereMetallisierlinie erfordern oder die Kapazitäten im Vergleich zur einstufigen Arbeitsweise verringern.

In der WO 2008/119359 A1 und in "Proceedings of 8th International Congress Molded Interconnect Devices", September, 24th-25th, 2008, Nuremberg-Fuerth, Germany, published by Research Association Interconnect Devices 3-D MID e.V., wirdebenfallsein lasergestütztes Verfahrenzurselektiven Metallisierung von Kunstoffoberflächen zur Herstellung von dreidimensionalen Schaltungsträgern offenbart, bei dem lediglich eine Oberflächenaufrauung des Kunststoffs erfolgt, ohne dass der Kunststoff ein Additiv enthält, welches nach der Laserstrukturierung als Katalysator für eine chemische Verkupferung wirken würde. Die Laserbehandlung erfolgt dabei innerhalb von Flüssigkeiten, im einfachsten Fall unter Wasser. Die anschließende Palladiumaktivierung und Metallisierung folgt dann wieder dem bekannten und zuvor beschriebenen Stand der Technik.

Es leuchtet ein, dass die oft dreidimensionale Strukturierung von Bauteilen mit dem Laser innerhalb von Flüssigkeiten eine in der Praxis nur umständlich zu realisierende Vorgehensweise darstellt und das Verfahren nicht wirtschaftlich erscheinen lässt.

Ausgehend von den Nachteilen der beschriebenen lasergestützten Verfahren zur Strukturierung und selektiven Metallisierung von Kunststoffoberflächen ist es Aufgabe der vorliegenden Erfindung, ein wesentlich verbessertes Verfahren bereitzustellen.

Erfindungsgemäß wird diese Aufgabe dadurch gelöst, dass der Kunststoff als Additiv mindestens eine Verbindung aus der Stoffgruppe der Alumosilikate, insbesondere der Tektoalumosilikate enthält und dass durch das Ablationsverfahren in den zu metallisierenden Bereichender Kunststoffoberfläche die Zugänglichkeitzudenindem Kunststoff eingearbeiteten Alumosilikaten und die Öffnung der Poren oder der Porenstruktur der Alumosilikate erreicht werden, um so die Einlagerung von Edelmetallen, insbesondere Palladium, zu erreichen, und dass schließlich eine außenstromlose Metallisierung durchgeführt wird, bei der sich Metall beginnend innerhalb der Poren oder der Porenstruktur auch in einem äußeren Randbereich der Poren abscheidet, sodass sich an der Oberfläche des Substrats eine flächige Metallisierungsschicht bildet. Insbesondere werden also in die Polymermatrix Substanzen eingebaut, die von ihrer Natur her mit Hohlraumstrukturen ausgestattet sind, wobei die Hohlraumstrukturen dieser Substanzen nach selektiver Ablation der Oberflächenhaut der aus der Polymermatrix hergestellten Kunststoffkörper offengelegt werden und danach eine Edelmetallbekeimung der ablatierten Bereiche nach den bekannten und in der Kunststoffmetallisierung bewährten Verfahren erfolgen soll. Beispielsweise werden hierzu in eine beliebige thermo- oder duroplastische Polymermatrix eine oder mehrere Verbindungen aus der Gruppe der natürlichen oder synthetischen Tektoalumosilikate, allgemeiner bekannt unter der Bezeichnung Zeolithe, eingearbeitet. Die primärenstrukturbildenen Einheitenvon Zeolithen sind TO₄-Tetraeder, wobei die T-Stelle von Silizium bzw. Aluminium eingenommen wird. Durch die Verbindung der einzelnen Einheiten entsteht ein dreidimensionales Netzwerk, wobei nahezu alle Sauerstoffatome mit zwei Tetraedernverbunden sind. Nachderempirischen Loewensteinschen Regelkönnen dabei jedoch keine zwei Aluminiumatome an einem gemeinsamen Sauerstoffatom gebunden sein. Da Aluminium nur dreifach positiv geladen, jedoch vierfach koordiniert ist, entsteht pro AIO₄-Tetraeder eine negative Ladung. Diese wird durch Kationen ausgeglichen, welche nicht unmittelbar in das Netzwerk eingebunden sind. Beispiele für derartige Ionen sind K, Na, Ca, Li,Mg,Sr,Ba,etc.,dieleichtausgetauschtwerdenkönnen.

Bei der Herstellung von synthetischen Zeolithen verwendet man unter anderem auch Ga, Ge, Be und P als Tetraeder-Kationen, sowie Alkali-, Erdalkali-, Seltenerdelemente und organische Komplexe als "extraframework cations".

Insoweit sollen erfindungsgemäß unter dem an sich für Zeolithe als Strukturgerüst aus AlO₄-und SiO₄-Tetraedern vorbehaltenen Begriff auch Strukturgerüste definiert und insoweit als modifizierte Zeolithe verstanden werden, in denen auf T-Position andere Elemente als Al und Si platziertsindwerdensollen.

Die Struktur und der Aufbau von Kanälen und Poren in Zeolithen spielen in der Praxis für Anwendungen als lonenaustauscher und bei der Verwendung als Katalysatoren eine besondere Rolle und werden auch in der vorliegenden Erfindung genutzt.

Überraschenderweisewurdenungefunden, dass beim Einarbeitenvongetrockneten natürlichen Zeolithen oder synthetischen Zeolithen bzw. geeignet modifizierten Zeolithen in Konzentrationen zwischen 1 und 40 Gew.-%, vorzugsweise zwischen 2 und 30 Gew.-% in eine Kunststoffmatrix bestehend aus einem beliebigen thermo- oderduroplastischen Polymer ein Material entsteht, dessen Weiterverarbeitung zu einem Kunststoffformkörper geeignet ist und welcher die Basis für die Herstellung von dreidimensionalen Schaltungsträgembildet.

Die Auswahlder Zeolitheerfolgtzweckmäßiganhandihrer Porenöffnungenzudeninihrem Inneren befindlichen Hohlräumen, bevorzugt aus der Gruppe der meso- bzw. makroporösen Zeolithe.

Geeignete Verfahren zur Formgebung der Polymermischung sind Spritzgussverfahren, Extrusion und Pressverfahren.

Es kannzum Zweckeder Modifizierungdermechanischenoderanderer Eigenschaftendes späteren Bauteils durchaus erforderlich oder sinnvoll sein, andere Additive parallel in die Polymermischungmit einzuarbeiten. Beispiele solcher zusätzlichen Additive sind Verstärkungsstoffe, farbgebende Füllstoffe oder Stoffe, die die rheologischen oder die allgemeinen Verarbeitungseigenschaften verbessern usw.

In einem zweiten Schritt wird nun an den Bereichen der Oberfläche des späteren Schaltungsträgers, die in einem nachfolgenden Metallisierschritt chemisch metallisiert werdensollen, einegeringe Schicht Materialabgetragen (ablatiert). Dazusindansichalle Material abtragenden Verfahren geeignet, wozu beispielsweise das mechanische Fräsen, einige Plasmaverfahren und besonders bevorzugt Verfahren zählen, die auf Basis elektromagnetischer Strahlung eines Lasers arbeiten.

Der Wellenlängenbereich der elektromagnetischen Strahlung eines Lasers kann dabei im Bereich zwischen 193 nm und 10.600 nm, bevorzugt im Bereich zwischen 355 nm und 1.064 nm liegen.

In einer weiteren Ausgestaltung der Erfindung können der Polymermatrix auch Stoffe beigemischt werden, die eine Erhöhung der Absorption des Laserlichts bei der jeweiligen Wellenlänge im Polymermaterial bewirken. Dabei werden bevorzugt Konzentrationen zwischen 0,1 und 10 Gew.-% bezogen auf das Gesamtgewicht der Polymermischung eingesetzt.

In den nun folgenden Schritten der Bekeimung und Aktivierung der selektiv ablatierten Oberfläche des Kunststoffkörpers wird auf die in der Beschreibung des Stands der Technik umrissenen Standardverfahren zurückgegriffen.

Es wird also zunächst der Kunststoffkörper entweder in eine palladiumhaltige Lösung getaucht und somit ionogen bekeimt oder durch Tauchen in eine Pd/SnCl₂-Lösung kolloidal bekeimt.

Erfindungsgemäß ist davon auszugehen, dass im Falle der ionogenen Bekeimung die Pd²⁺-Ionen in die Hohlräume des nun freigelegten Zeoliths eindiffundieren und dort gegen Kationen des Zeolithgerüsts ausgetauscht werden.

Ebenso ist erfindungsgemäß davon auszugehen, dass im Falle der kolloidalen Bekeimung - eine angepasste Porenweite durch Wahldesgeeigneten Zeolithsvoraussetzend - die Palladium-Zinn-Cluster in die Zellstrukturen des Zeoliths hineindiffundieren.

Nach dem gründlichen Spülen der so vorbehandelten Teileerfolgterfindungsgemäßdurch Tauchen in die entsprechende Reaktionslösung die Reduktion zum metallischen Palladium bzw. die Spaltung des Schutzkolloids, undzwardirektinden Hohlräumen des Zeoliths.

Schließlich werden erfindungsgemäß die so vorbehandelten Oberflächen in einem handelsüblichen chemischen Kupferbadbehandelt,wobeiangenommenwird,dassdie Verkupferung innerhalb der Hohlräume des Zeoliths startet und sich dann auf der Oberfläche der ablatierten Bereiche fortsetzt und somit eine gute Haftfestigkeit der fertig metallisierten Schicht bewirkt.

Im Folgenden wird die Erfindung anhand von Ausführungsbeispielen näher erläutert:

### Ausführungsbeispiele

### Variante 1

I neinerFeinprallmühle vom Typ 100 UPZ-II der Fa. Alpine wurde ein naturfarbenes Granulat aus einem Polycarbonat-Acrylniril-Butadien-Styrol-Blend des Typs Bayblend T45 der Fa. Bayer AG, welches zuvor über die Dauer von 4 Stunden bei einer Temperatur von 110 °C getrocknet wurde, gemahlen.

540 g des so erhaltenen Polymerpulvers wurden für 15 Minuten in einem Taumelmischer mit 60 g eines modifizierten 13X-Typ Zeolith der Fa. Süd-Chemie, welches zuvor 5 Stunden bei 250 °C im Vakuum entwässert wurde, gemischt.

In einem Compounder der Fa. Dr. Collinwurde diese Mischunghomogenisiert und anschließend das nach dem Zerkleinern erhaltene Kunststoffgranulat in einer Spritzgießmaschine der Fa. Dr. Boy zu plattenförmigen Probekörpern der Abmessungen 60 mm x 60 mm x 2 mm verspritzt.

### Variante 2

Analog zu dem ersten Prozessschritt in Variante 1 wurde ein naturfarbenes Polybutylenterephthalat (PBT) vom Typ Ultradur B4520 der Fa. BASF, nachvorheriger TrocknungfürdieDauervon3Stundenbei120 °C, gemahlen.

480 g des so erhaltenen Polymerpulvers wurden für 15 Minuten in einem Taumelmischer mit 60 g eines modifizierten Pentasil-Typ Zeolith der Fa. Zeochem, welches zuvor 5 Stunden bei 250 °C im Vakuum entwässert wurde, zusammen mit 60 g Talkum mit der Handelsbezeichnung Finntalk M03-SQ, welches vorher für 2 Stunden bei 200 °C getrocknet wurde, gemischt.

Analog zu Variante 1 wird diese Mischung compoundiert und zu plattenförmigen Probekörpern verspritzt.

### Variante 3

Analog dem ersten Prozessschritt in Variante 1 wurde ein zuvor mit 1 % des Farbstoffs "Red X2GP" von der Fa. Albion-Coloursroteingefärbtesundmit30 % Glasfaser gefülltes, partiell aromatisches Copolyamid vom Typ HT2V-3X VO der Fa. EMS, nach vorherigerTrocknung fürdieDauervon10Stundenbei80 °C, gemahlen.

516 g des so erhaltenen Polymerpulvers wurden für 15 Minuten in einem Taumelmischer mit 33 g eines modifizierten 13X-Typ Zeolith der Fa. Süd-Chemie, welches zuvor 5 Stunden bei 250 °C im Vakuum entwässert wurde, zusammen mit 18 g eines calcinierten IR-Absorbers vom Typ Polestar 200R der Fa. Imerys Performance & Filtration Materials gemischt.

Analog zu Variante 1 wird diese Mischungcompoundiertundzurotgefärbten plattenförmigen Probekörpern verspritzt.

### Variante 4

Auf eine aus den Varianten 1 oder 2 erhaltene Kunststoffplatte wurden mit einem UV-Laser der Wellenlänge 355 nm bei einer Pulsenergievon 35µ Jundeiner Geschwindigkeit von 500 mm/s mit einer Überfahrt rechteckige Teststrukturen geschrieben.

### Variante 5

Auf eine aus Variante 3 erhaltene Kunststoffplatte wurden mit einem Nd-YAG-Laserder Wellenlänge 1.054 nm bei einer Pulsenergie von 120 µJ und einer Geschwindigkeit von 4000 mm/s mit zwei Überfahrten rechteckige Teststrukturen geschrieben.

### Variante 6

In die plane Oberfläche einer aus dem Variante 1 erhaltenen Kunststoffplatte wurden unter Zuhilfenahme einer CNC-Fräsmaschine und unter Benutzung eines zweischneidigen Fräsers mit einem Durchmesser von 1,5 mm und einer Drehzahl von 18.000 U/min mehrere rechteckige Vertiefungenmiteiner Tiefevon 0,15 mm, gemessen von derPlattenoberfläche, gefräst.

### Variante 7

Eine in den Varianten 4 bis 6 behandelte Platte wurde in eine wässrige, Pd²⁺-haltige Lösung mit der beispielhaften Zusammensetzung 200 ml/l MID-Aktivator Ni der Fa. Atotech und 5 ml/l konzentrierter H₂SO₄ für15MinutenunterBadbewegungbei50 °C getaucht. Danach wurde die Platte in einer Zweifach-Fließspülkaskade und anschließend in deionisiertem Wasser gespült.

Anschließend wurde die Platte in eine Dimethylamininoboran enthaltende Reduktionslösung der beispielhaften Zusammensetzung 25 ml/l Ultraplast BL 2220 Conditioner und 2,5 ml/l Ultraplast BL 2230 Additive der Fa. Enthone für 5 Minuten bei 40 °C unter Badbewegung behandelt und anschließend erneut gespült.

Die so vorbehandelte Platte wurde unmittelbar danach in ein aktiviertes stromloses Kupferbad des Typs Circuposit 4500 der Fa. Dow Chemical mit einer Arbeitstemperatur von 54 °C eingehängt und nach ca. 45 Minuten dem Bad entnommen.

Nach dem gründlichen Spülen wurde die Platte getrocknet. An den Stellen der Platte, die zuvor mit dem Laser behandelt bzw. in die vertiefte Strukturen eingefräst worden waren, hatten sich selektiv und kantenscharf gleichmäßige, ca. 4 um dicke Kupferschichten haftfest abgeschieden.

### Variante 8

Eine weitere in den Varianten 4 bis 6 behandelte Platte wurde 5 Minuten in eine kolloidale Pd-Katalysatorlösung der beispielhaften Zusammensetzung 250 ml/l 37%-ige HCl, 170 ml/l PdCl₂ und 15 g/l SnCl₂ unterBadbewegungbei30 °C getaucht. Danach wurde die Platte in einer Zweifach-FließspülkaskadeundanschließendindeionisiertemWassergespült.

Anschließend wurde die Platte in einer HBF₄ enthaltenden Beschleunigerlösung des Typs Enplate Accelerator 860 der Fa. Enthone für 3 Minuten bei Raumtemperatur unter Badbewegungbehandeltundanschl ießend erneut gut gespült.

Die so vorbehandelte Platte wurde unmittelbar danach in ein aktiviertes stromloses Kupferbad des Typs M-Copper 85 der Fa. Mac Dermidmiteiner Arbeitstemperaturvon 48 °C eingehängt und nach ca. 30 Minuten dem Bad entnommen.

Nach gründlichemSpülenwurdediePlattegetrocknet.AndenStellenderPlatte,diezuvor mit dem Laser behandelt bzw. in die vertiefte Strukturen eingefräst worden waren, hatte sich selektiv und kantenscharf eine gleichmäßige, ca. 2 um dicke Kupferschicht haftfest abgeschieden.

### Variante 9

Eine aus den Varianten 3 und 5 erhaltene und nach Variante 7 selektiv verkupferte Probeplatte wurde unmittelbar nach der Verkupferung einer Pd-Aktivierungineinem handelsüblichen Bad des Typs Ronamerse SMT Catalyst CF der Fa. Dow Chemical unterzogen und in einem chemischen Nickelbad des Typs N iposit LT mit ca. 4 um NiP (4-6 % Phosphor-Gehalt) vernickelt und anschließend mit einer Flash-Goldschicht mit ca. 0,1 um Dicke aus einem stromlosen Goldbad des Typs Aurolectroless SMT-G, beide Bäder von der Fa. Dow Chemical, versehen.

Auf den nunmehr verkupferten, vernickelten und vergoldeten Feldern der Platte wurden Dots einer bleifreien Lotpaste dispenst und in diese Dots vorverzinnte Kupferdrähte eingelegt. In einer Dampfphasenlötanlage, die mit dem perfluorierten Polyether "Galden HS/240" (Handelsbezeichnung der Solvay Solexis S.p.A.) mit einer Siedetemperatur von 240 °C beschickt war, wurde die Lotpaste aufgeschmolzen. Nach dem Verlöten war ein blasenfreier Lotverlaufzuerkennenund derAbzugstestderangelötetenDrähteoffenbarteeinesehrgute Haftfestigkeit der Metallisierung auch nach dem Lötprozess.

## Patentansprüche

1. Verfahren zur selektiven Metallisierung eines Substratsmiteinemwesentlichen Materialanteil aus einem Kunststoff, welcher ein Additiv aufnimmt oder trägt, bei dem in den zu metallisierenden Bereichen eine oberflächennahe Schicht des Substrats mittels eines Ablationsverfahrens abgetragen wird, **dadurch gekennzeichnet, dass** der Kunststoffals Additivmindestenseine Verbindungaus der Stoffgruppeder Alumosilikate, insbesondere der Tektoalumosilikate, enthält und dass durch das Ablationsverfahren in den zu metallisierenden Bereichen der Kunststoffoberfläche die Zugänglichkeit zu den in dem Kunststoff eingearbeiteten Alumosilikaten und die Öffnung der Poren oder der Porenstruktur der Alumosilikate erreicht werden, um so die Einlagerung von Edelmetallen, insbesondere Palladium, zu erreichen, und dass schließlich eine außenstromlose Metallisierung durchgeführt wird, bei der sich Metall beginnend innerhalb der Poren oder der Porenstruktur auch in einem äußeren Randbereich der Poren abscheidet, sodass sich an der Oberfläche des Substrats eine flächige Metallisierungsschicht bildet.

2. Verfahren nach Anspruch 1, **dadurch gekennzeichnet, dass** für das Ablationsverfahren eine elektromagnetische Strahlung, insbesondere eine Laserstrahlung, eingesetzt wird.

3. Verfahren nach Anspruch 2, **dadurch gekennzeichnet, dass** die Wellenlänge der elektromagnetischen Strahlung bzw. des Lasers in einem Bereich zwischen 193 nm und 10.600 nm liegt, bevorzugt in einem Bereich zwischen 350 nm und 1.100 nm.

4. Verfahren nach zumindest einem der vorhergehenden Ansprüche, **dadurch gekennzeichnet, dass** die offenen Porendurchmesser der verwendeten Alumosilikate zumindest größer als die kinetischen Durchmesser der an der Einlagerungsreaktion beteiligten Reaktanten sind.

5. Verfahren nach zumindest einem der vorhergehenden Ansprüche, **dadurch gekennzeichnet, dass** der Gehalt des Additivs zwischen 1 und 40 Gewichtsprozent, vorzugsweise zwischen 2 und 30 Gewichtsprozent, an der Gesamtmischung des Kunststoffs beträgt.

6. VerfahrennachzumindesteinemdervorhergehendenAnsprüche, **dadurch gekennzeichnet, dass** der Kunststoff ein thermoplastischer oder duroplastischer Kunststoff ist.

7. Verfahren nach zumindest einem der vorhergehenden Ansprüche, **dadurch gekennzeichnet, dass** die Metallisierung in einem chemisch reduktiven Metallbad (Kupferbad) chemisch durchgeführt wird.

8. Verfahren nach zumindest einem der vorhergehenden Ansprüche, **dadurch gekennzeichnet, dass** der thermoplastische Kunststoff in spritzgegossener oder strangextrudierter Form oder in Form einer Folie ausgeführt ist.

9. Verfahren nach zumindest einem der vorhergehenden Ansprüche, **dadurch gekennzeichnet, dass** der duroplastische Kunststoff als Pressmasse oder in flüssiger Form vorliegt.

10. Verfahren nach zumindest einem der vorhergehenden Ansprüche, **dadurch gekennzeichnet, dass** der Kunststoff neben dem Additiv ein oder weitere anorganische oder organische Additive enthalten kann.

11. Verfahren nach Anspruch 10, **dadurch gekennzeichnet, dass** das weitere Additiv im infraroten, grünen und/oder ultravioletten Wellenlängenbereich ein Absorptionsmaximum enthält und den Absorptionsgrad des Kunststoffs erhöht.

12. Verfahren nach zumindest einem der vorhergehenden Ansprüche, **dadurch gekennzeichnet, dass** ein Stofftransport von ionogenem oder kolloidalem Edelmetall in die selektiv freigelegte Porenstruktur in der Kunststoffmatrix erfolgt und dass dort nach bekannten Folgereaktionen eine chemische Kupferabscheidung startet.

13. Verfahren nach zumindest einem der vorhergehenden Ansprüche, **dadurch gekennzeichnet, dass** als Edelmetall ein Palladium oder eine Palladiumverbindung eingesetzt wird.

14. VerfahrennachzumindesteinemdervorhergehendenAnsprüche, **dadurch gekennzeichnet,dass** es zur Herstellung von dreidimensionalen Schaltungsträgern (MID) verwendet wird.

15. Ein Schaltungsträger mit einer Metallisierung auf einem Substrat, hergestelltmiteinem Verfahren nach zumindest einem der vorhergehenden Ansprüche.
